# EUROPÄISCHE PATENTANMELDUNG

(11) **EP 3 826 079 A1**
(43) Veröffentlichungstag der Anmeldung: **26.05.2021**
(21) Anmeldenummer: 20172069.5
(22) Anmeldetag: 29.04.2020
(51) Int. Cl.: H01L 49/02, G06N 3/063, G11C 11/24, H01L 29/93

(54) **KAPAZITIVES SYNAPTISCHES BAUELEMENT MIT HOHEN HUBVERHÄLTNIS UND VERFAHREN ZU DESSEN ANSTEUERUNG**

(30) Priorität: 21.11.2019 DE 102019008095
(71) Anmelder: Semron GmbH, 01309 Dresden (DE)
(72) Erfinder: Demasius, Kai-Uwe, 04109 Leipzig (DE); Kirschen, Aron, 01309 Dresden (DE)
(74) Vertreter: Lippert Stachow Patentanwälte Rechtsanwälte Partnerschaft mbB

(57) **Zusammenfassung**

Der Erfindung, die ein Kapazitives synaptisches Bauelement bestehend aus einem Schichtaufbau aus Gateelektrode (1), Ausleseelektrode (5) und Schicht mit veränderlichem Abschirmverhalten gegenüber eines elektrischen Feldes der Gateelektrode (3), einem aktiven Speicherdielektrikum (2) und einem passiven Dielektrikum (4), wobei die Schicht mit veränderlichem Abschirmverhalten (3) zwischen der Gateelektrode (1) und Ausleseelektrode (5) angeordnet ist, und ein Verfahren zum Beschreiben und Auslesen dieses Bauelements, liegt die Aufgabe zugrunde, ein hohes kapazitives Hubverhältnis zu ermöglichen, ohne dabei den Plattenabstand zu verändern, oder die laterale Skalierfähigkeit einzuschränken. Dies wird dadurch gelöst, dass sich das aktive Speicherdielektrikum (2) zwischen Gateelektrode (1) und Schicht mit veränderlichem Abschirmverhalten (3) befindet und das passive Dielektrikum (4) zwischen der Schicht mit veränderlichem Abschirmverhalten (3) und Ausleseelektrode (5) befindet, dass das aktive Speicherdielektrikum (2) im Stande ist, mehrere Zustände zu speichern, und dass das aktive Speicherdielektrikum ausgebildet ist, die kapazitive Kopplung oder Abschirmung gegenüber der Gatespannung zu verschieben.

## Beschreibung

Die Erfindung betrifft ein kapazitives synaptisches Bauelement mit hohen Hubverhältnis und Verfahren zu dessen Ansteuerung.

Künstliche Neuronalen Netze haben in den vergangen Jahren eine steigende Bedeutung in Bild- und Objekterkennung und Datenverarbeitung gewonnen und werden zukünftig eine wichtige Relevanz haben in der Implementierung von künstlicher Intelligenz.

Künstliche neuronale Netze sind biologisch inspiriert und bestehen aus Neuronen, in welchen die Verarbeitung von Information stattfindet und diese sind mit vielen weiteren Neuronen über gewichtete Verbindungen (sogenannte Synapsen) verknüpft. Das Ausgangssignal eines Neuron wird dabei entweder stark abgeschwächt in einer solchen Verknüpfung oder gut übertragen zum nächsten Neuron, wobei diese synaptische Verknüpfung eine Plastizität aufweist, das heißt graduell gestärkt oder geschwächt werden kann. Die Eingangssignale eines Neurons nach der Gewichtung werden aufsummiert und bei biologischen neuronalen Netzen zeitlich integriert und bei Erreichen eines Schwellwertes feuert dieses Neuron ein neues Signal aus. In sogenannten mehrlagigen Perzeptronen, werden die Eingangssignale eines Neurons auch aufsummiert, dort jedoch nicht-linear verzehrt, z.B. in Form einer sigmoid-Funktion oder tanh-Funktion oder einer Rectified Linear Unit (ReLU).

Das Problem heutiger Rechnerarchitekturen besteht darin, dass diese zum größten Teil auf der sogenannten Von-Neumann Architektur mit einer strikten Trennung zwischen Speicher und Prozessor beruhen und, dass zur Berechnung von künstlichen Neuronalen Netzen ganz viele Multiplikationen mit Summationen nötig sind. Die synaptische Gewichtung stellt letztlich eine Multiplikation mit einem Gewicht dar und die Summation erfolgt an den Neuroneneingängen. Da nicht alle Gewichte in Prozessornähe gespeichert werden können müssen diese in der Regel vom Arbeitsspeicher in den Prozessor geladen werden und dann multipliziert und aufsummiert werden, was extrem energieaufwendig ist.

Aus diesem Grund wurden verschiedene neuromorphe Rechnerarchitekturen in den vergangen Jahren entwickelt, welche eine energieeffiziente Umsetzung von künstlichen neuronalen Netzen ermöglichen soll. Beispielsweise sind Matrixstrukturen in, welchen die Gewichte gespeichert sind besonders geeignet, da die Gewichtung von künstlichen neuronalen Netzen als Vektor-Matrix Multiplikation aufgefasst werden kann. Der Eingangsvektor, welche an die Wortlinien einer Matrix angelegt werden, entsprechen dabei den Ausgangssignalen einer Lage Neuronen, diese werden an den Kreuzungspunkten der Matrix, in welchen die Gewichte als Analogwerte gespeichert werden, multipliziert und an der Bitleitung werden die Signale aufsummiert. Das summierte Ausgangssignal an den Bitleitungen wird mit der nächste Lage Neuronen verbunden (Tsai et al.: Recent progress in analog memory-based accelerators for deep learning).

Beispiele zur Implementierung der Gewichtung in einer Matrix umfassen resistive Speicherbauelemente, wie Memristoren, Phase change memory oder Floating Gate Transistoren. Bei resistiven Speicherbauelementen erfolgt die Multiplikation dabei über das Ohmsche Gesetz: I=GxU, wobei die Spannung U der Eingang an der Wortleitung ist und G der frei einstellbare Leitwert des resistiven Speicherbauelementes ist. Der Strom I wird auf der Bitleitung aufsummiert. Auf diese Weise geschieht die Berechnung im Speicher direkt und der Datentransfer, wie bei der von-Neumann Architektur entfällt.

Ein essentieller Nachteil von resistiven Bauelementen ist, dass diese eine Verlustleistung haben. Aus diesem Grund ist die Implementierung mit kapazitiven Bauelementen von Vorteil, da diese theoretisch gesehen, von nicht-idealitäten abgesehen, nur eine Blindleistung besitzen und keinen statischen Stromverbrauch besitzen (Di Ventra et al.: Circuit elements with memory- memristors, memcapacitors, and meminductors, Proceedings of the IEEE oder WO2016068886A1, US5146542A, WO1991018360A1).

Es wurden bereits verschiedene Bauelemente zur Implementierung solcher memkapazitiven Bauelemente vorgeschlagen. Beispiele sind Memristor ähnliche Bauelemente, wobei die Dotierungsfront von Sauerstoffvakanzen den Plattenabstand eines Kondenstors manipuliert (US20120014170A1). Andere Beispiele sind Memristoren mit paralleler parasitärer Kapazität und einer Serienkapazität, wobei die parallele parasitäre Kapazität eine deutliche geringe Kapazität aufweisen muss, als die Serienkapazität, was in dem genannten Beispiel durch eine kleine Fläche realisiert wird (US2019303744A1 or Wang et al.: Capacitive neural network with neuro-transistors). Die parasiäre Kapazität wird durch den Memristor kurzgeschlossen, wenn eine hohe Gesamtkapazität eingestellt werden muss. Andere Beispiele umfassen mikromechanische Bauelemente (Emara et al.: Non-volatile low-power crossbar memcapacitor-based memory), bei welchen der Plattenabstand flexibel eingestellt werden kann, oder Bauelemente auf Basis von Ionen (Krems et al.: Ionic Memcapacitive Effects in Nanopores) oder dem Tunneleffekt (Martinez et al.: Solidstate memcapacitor).

Den meisten memcapacitven Bauelementen ist gemein, dass die Einstellung der Kapazität über die Gleichung ***C*** = ***εᵣε*₀·*A*/*d*** erfolgt. Dabei wird zum Beispiel im Falle von US20120014170A1 die Kapazität durch einen veränderten Plattenabstand d variiert. Da man in einem synaptischen Bauelement ein möglichst hohes Verhältnis aus minimaler und maximaler Kapazität erzielen möchte ist es notwendig einen großen Unterschied zwischen minimalen und maximalen Plattenabstand d zu erzielen. Problem hierbei ist, dass ein sehr großes d für die minimale Kapazität, die laterale Skalierung zu kleinen Technologieknoten des Bauelementes einschränken würde. Ein sehr kleines d für die maximale Kapazität würde andererseits zu sehr großes Tunnelströmen zwischen den Kapazitätsplatten führen. Beispielsweise müsste bei einem Hubverhältnis zwischen minimaler und maximaler Kapazität von >1:100 und einer maximalen Dicke d von 30 nm eine minimale Dicke von 0.3 nm eingestellt werden für die maximale Kapazität. Bei solchen Dicken tritt direktes Tunneln auf und der Vorteil kapazitiver Bauelemente theoretisch keine Verlustleistung zu haben würde zu nichte gemacht. Ein veränderte Plattengröße A hätte ebenfalls ein laterales Skalierungsproblem und eine Variation der relativen Dielektrizitätskonstante ***εᵣ*** schränkt die Materialauswahl ein.

In Patent WO002018069359A1 wurde bereits eine kapazitive Matrixstruktur vorgestellt, welche eine Schicht mit veränderlicher Abschirmlänge besitzt, jedoch hauptsächlich zur Speicherung digitaler Informationen diente und Verfahren beschrieb wie einzelne Speicherzellen ausgewählt werden können, was bei neuromorphen Anwendungen weniger relevant ist.

Ebenso hohe Relevanz in Zukunft werden nicht nur synaptische Bauelemente mit zwei Anschlüssen, sondern mit einem zusätzlichen Modulationsanschluss, um Verknüpfungen in Abhängigkeit der Aktivität einer weiteren Größe zu variieren. Solche Möglichkeiten wurden bisher nur für resistive Bauelemente vorgestellt (Yang et al.: Memristive Physically Evolving Networks Enabling the Emulation of Heterosynaptic Plasticity).

Aufgabe dieser Erfindung war es daher ein kapazitives synaptisches Bauelement mit Analogwertspeicherung zu entwickeln, welches ein hohes kapazitives Hubverhältnis ermöglicht ohne dabei den Plattenabstand zu verändern, oder die laterale Skalierfähigkeit einzuschränken. Zudem soll es einen weiteren Modulationsanschluss geben.

Erfindungsgemäß wird diese Aufgabe durch ein Kapazitives synaptisches Bauelement mit den Merkmalen des Anspruches 1 gelöst.

Das Kapazitive synaptische Bauelement besteht aus einem Schichtaufbau aus Gateelektrode (1), Ausleseelektrode (5) und Schicht mit veränderlichem Abschirmverhalten (3), einem aktiven Speicherdielektrikum (2) und einem passiven Dielektrikum (4), wobei die Schicht mit veränderlichem Abschirmverhalten (2) zwischen der Gateelektrode (1) und Ausleseelektrode (5) angeordnet ist.
Dabei befindet sich erfindungsgemäß das aktive Speicherdielektrikum (2) zwischen Gateelektrode (1) und Schicht mit veränderlichem Abschirmverhalten (3) und das passive Dielektrikum (4) zwischen der Schicht mit veränderlichem Abschirmverhalten (3) und Ausleseelektrode (5).
Weiterhin ist das aktive Speicherdielektrikum (2) ausgebildet, mehrere Zustände zu speichern.

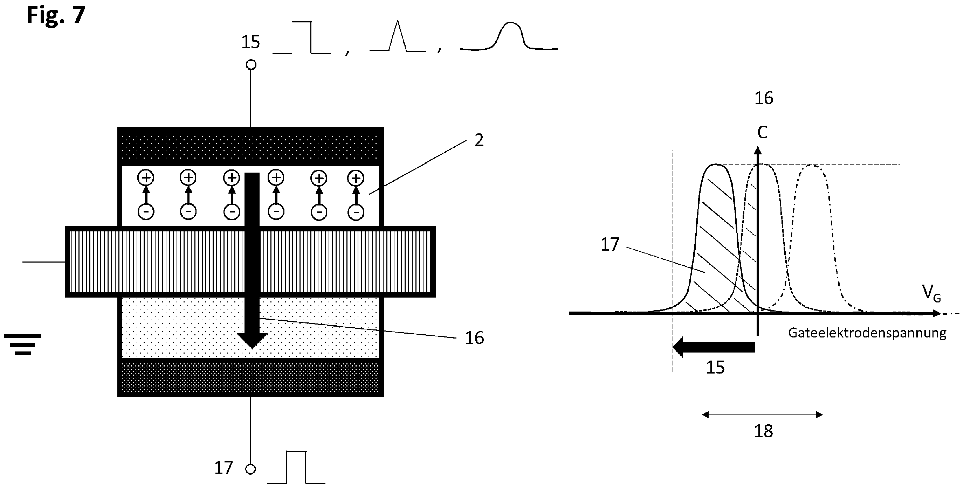

Dabei ist das aktive Speicherdielektrikum so ausgebildet, die kapazitive Kopplung oder Abschirmung gegenüber der Gatespannung zu verschieben, wie dies u.a. in Fig. 7 rechts dargestellt ist.

Ausführungsformen sind in den abhängigen Ansprüchen 2 bis 8 dargestellt.
Weiterhin wird die erfindungsgemäße Aufgabenstellung durch ein Verfahren gemäß Anspruch 9 gelöst. Verfahrensseitige Ausgestaltungen sind in den abhängigen Ansprüchen 10 bis 14 dargestellt.

In folgenden Zeichnungen werden günstige Ausführungen näher erläutert:
Fig. 1: Genereller Aufbau des kapazitiven synaptischen Bauelementes mit typischer kapazitiver Kopplung (16) zwischen Gateelektrode (1) und Ausleseelektrode (5) nach Anspruch 1 und 2.
Fig. 2: Aufbau eines kapazitiven synaptischen Bauelementes mit seitlichen p- (6) dotierten und n-(7) dotierten Gebieten nach Anspruch 3.
Fig. 3: Aufbau eines kapazitiven synaptischen Bauelementes mit seitlicher Dotierung (8) nach Anspruch 4.
Fig. 4: Aufbau eines kapazitiven synaptischen Bauelementes mit veränderlichem Widerstand (9) nach Anspruch 5.
Fig. 5: Anordnung des kapazitiven synaptischen Bauelements in einer Matrix nach Anspruch 6.
Fig. 6: Kapazitives synaptisches Bauelement mit ferroelektrischen Material (13) als aktives Speicherdielektrikum (2) oder Ladungsfangstellen (14) im aktiven Speicherdielektrikum (2) nach Anspruch 7 und 8.
Fig. 7: Auslesen des kapazitiven synaptischen Bauelementes mit einem Spannungspuls (15) an der Gateelektrode (1) nach Anspruch 9.
Fig. 8: Graduelles Schreiben des aktiven Speicherdielektrikums (2) nach Anspruch 9.
Fig. 9: Moduliertes Schreiben des aktiven Speicherdielektrikums (2) mit einer symmetrische Durchlass- oder Sperrspannung an den pin-Übergang (22) nach Anspruch 11.
Fig. 10: Gewichtung zwischen Spannungspuls beim Lesen (15) und symmetrische Durchlass- oder Sperrspannung an den pin-Übergang (22) nach Anspruch 12.

Die Abschirmschicht (3) kann ein elektrisches Feld von der Gateelektrode (1) ausgehend gut abschirmen oder zu der unteren Ausleseelektrode (5) transmittieren. Diese Transmission geht mit einer kapazitiven Kopplung (16) einher, wobei das Hubverhältnis zwischen Transmission und Abschirmung sehr groß sein kann. Das aktive Speicherdielektrikum (2) justiert letztlich den Grad der Kopplung für eine bestimmte Spannung und es soll im Stande sein mehrere Zustände speichern zu können, um eine Analogwertbildung zu ermöglichen. In bestimmten Fällen, welche in den nachfolgenden Ausführungen behandelt werden kann das aktive Speicherdielektrikum (2) auch mit einem passiven Dielektrikum (4) ersetzt werden.

Im Falle von Anspruch 2 besteht die Abschirmschicht (3) aus einem Halbleitermaterial. Ein Halbleitermaterial kann in bestimmten Spannungsbereichen der Gatespannung zu einer Inversion oder Akkumulation getrieben werden oder in einem dazwischenliegenden Spannungsbereich in eine Verarmung. Wenn das Halbleitermaterial sich in der Inversion oder Akkumulation befindet wird das Feld von der Gateelektrode (1) praktisch komplett abgeschirmt und es findet keine Kopplung zur Ausleseelektrode (5) statt. Im Falle einer Verarmung kann das Halbleitermaterial komplett verarmt werden, dies würde zu einer kapazitiven Kopplung (16) zur Ausleseelektrode (5) führen. Es lassen sich sehr hohe Hubverhältnisse zwischen Kopplung und nicht-Kopplung erzielen, da die Inversions- und Akkumulationsschichten sehr dünn sind im Vergleich zu Verarmungsschichten.

Nach Anspruch 3 kann die Abschirmschicht (3) auch seitliche hochdotierte p-(6) und n-(7) Gebiete haben, welche jeweils Kontakte haben und es ermöglichen, dass der Halbleiter in kurzer Zeit in Akkumulation und Inversion getrieben werden kann und die Inversionsladungen nicht erst thermisch generiert werden müssen, was sonst relativ viel Zeit kostet. Damit soll unteranderem symmetrisches Schreiben/Löschen ermöglicht werden, das heißt die Änderung des aktiven Speicherdielektrikums wird für negative und positive Spannungen gleichermaßen verändert in verschiedene Richtungen, da die Inversionsladungen und Akkumulationsladungen zu einem gleichermaßen hohen positiven und negativen Feld in dem aktiven Speicherdielektrikum führen. Symmetrisches Schreiben ist eine Grundvoraussetzung zur effizienten Implementierung von Lernalgorithmen in neuronalen Netzen, damit die Gewichte kontrolliert verändert werden können.

Die Kapazitive Kopplung (16) zwischen Gateelektrode (1) und Ausleseelektrode (5) führt zu einem Kopplungsfenster, welches jeweils endet bei der Inversions- bzw. Akkumulationsspannung an der Gateelektrode (1). Ebenfalls nach Anspruch 4 ist es denkbar, dass die Abschirmschicht (3) durch einen oberen Halbleitergebiet mit seitlichen dotierten Gebieten (8) ausgebildet wird, wobei diese Abschirmschicht (3) immer dann aktiv wird, wenn der Halbleiter in Inversion getrieben wird. Im Falle von Verarmung koppelt das Feld durch den Halbleiter in den unteren Halbleiterbereich, welcher das passive Dielektrikum (4) bildet, zu der Ausleseelektrode (5). Die Ausleseelektrode (5) kann entweder auf der Substratrückseite ausgebildet sein oder in der Mitte, beispielsweise durch ein hochdotiertes Gebiet.

Nach Anspruch 5 kann die Abschirmschicht (3) auch aus einem veränderlichen Widerstand bestehen, welcher die Gewichtung speichert (9). Dies kann beispielsweise ein Memristor sein. Das aktive Speicherdielektrikum (2) wird durch ein passives Dielektrikum (4) ersetzt. Beide Dielektrika bilden dabei zwei in Reihe geschaltete Kondenstoren und der veränderliche Widerstand (9) ist an der Anschlussstelle zwischen den beiden Kondensatoren geschaltet. Wenn der Widerstand niedrig ist und geerdet wird, koppelt praktisch kein Signal zwischen Gateelektrode (1) und Ausleseelektrode (5) durch. Dies geschieht erst wenn der Widerstand hoch genug ist.

Die Ausführung in Anspruch 6 beschreibt die Anordnung des Bauelementes nach den Ansprüchen 1-5 in einer Matrix. Dabei geht die Gatelektrode (1) in die Wortleitung (10) über. An den Wortleitungen (10) werden die presynaptischen Neuronen angeschlossen. Die Ausleseelektrode (5) geht in die Bitleitung (12) über und dort werden die Ströme/Ladungen (17) summiert. Die Abschirmschicht (3) wird mit der Abschirmleitung (11) verbunden und ist parallel zur Bitleitung (12) ausgerichtet. Im Falle wie in Anspruch 3 und 4 beschrieben, wo seitliche dotierte Gebiete sich an der Abschirmschicht (3) befinden, würde für jedes Gebiet eine getrennte Abschirmleitung (11) angebracht werden, das heißt zwei Stück.

Nach Anspruch 7 kann das aktive Speicherdielektrikum (2) ein ferroelektrisches Material (13) sein, wobei die Polarisation zu einer Spannungsverschiebung der Kopplungskurven führt. Die Analogspeicherung erfolgt hierbei mittels der Domänenstruktur des Ferroelektrikums. Dabei kann entweder eine Domänennukleation stattfinden oder bestehende Domänen umgeschaltet werden.

Nach Anspruch 8 kann das aktive Speichermedium auf Ladungsfangstellen (14) beruhen, welche in Abhängigkeit der eingefangenen Ladungsmenge zu einer Spannungsverschiebung der Kopplungskurven führt (18). Die eingefangene Ladungsmenge kann dabei graduell verändert werden.

Im folgenden werden weitere Verfahren beschrieben, welche den Betrieb des Bauelementes und der Matrix näher beleuchten.

In einem Verfahren nach Anspruch 9 wird das Auslesen des Bauelementes/der Matrix näher beschrieben. Das Auslesen umfasst wie die Gewichtung/Multiplikation eines Eingangssignals am Gate (1)/Wortleitung (10) abläuft. Hierzu wird an die Gatelektrode (1)/Wortleitung (10) ein Spannungspuls (15) angelegt, während die Abschirmschicht (3)/Abschirmleitung (11) geerdet ist und die kapazitive Kopplung führt zu einer Aufladung (17) in der Ausleseelektrode (5)/Bitleitung (12), wobei die Verschiebung der Kopplung (18) durch das Speicherdielektrikum (2) letztlich zu einer unterschiedlichen Aufladung (17) führt. An der Ausleseelektrode (5)/Bitleitung (12) kann ein Strom oder die Gesamtladung gemessen werden.

Weiterhin werden im Falle der Matrixanordnung, nach Anspruch 10 die Spannungspulse (15) parallel an die Wortleitungen (10) angelegt, sodass an den Kreuzungspunkten die Multiplikation gleichzeitig stattfindet und die korrespondierende Ladung an der Bitleitung (12) aufsummiert wird.

Das Schreiben erfolgt nach Anspruch 9 dadurch, dass die Spannungsdifferenz zwischen Gateelektrode (1)/Wortleitung (10) und Abschirmschicht (3)/Abschirmleitung (11) ausgenutzt wird und ein graduelles Beschreiben entweder über die Spannungshöhe (20) oder zeitliche Spannungslänge (19) erfolgen kann.

In neuronalen Netze könnte zukünftig, wie bereits erwähnt, auch die Modulation einer Kopplung zwischen zwei Elektroden eine Rolle spielen. Dieser Fall wird z.B. wie in Anspruch 11 dadurch abgedeckt, dass an den seitlichen p- (6) und n- (7) Gebieten eine Sperr- oder Durchlassspannung (22) angelegt wird. Im Falle einer Sperrspannung wird das intrinsische oder schwach dotierte Gebiet verarmt, wodurch der Spannungsbereich einer kapazitiven Kopplung (16) zur Ausleseelektrode (5) erweitert wird (größeres Kopplungsfenster). Dies geht automatisch damit einher, dass das elektrische Feld zwischen Abschirmschicht (3) und Gateelektrode (1) abnimmt, wegen der darunter liegenden Serienkapazität durch das passive Dielektrikum (4). Somit ist das Schreibfeld zwischen Abschirmschicht (3) und Gateelektrode (1) insgesamt schwächer, als ohne Verarmung. Im Falle von einer Durchlassspannung wird das intrinsische oder schwach dotierte Gebiet mit Ladungsträgern geflutet und das Schreibfeld zwischen Abschirmschicht (3) und Gateelektrode (1) steigt. Insgesamt kann also somit durch den Verarmungszustand der Abschirmschicht (3) (gesteuert durch den pin-/psn-Übergang) also eine zusätzliche Modulation erreicht werden.

Ebenfalls denkbar ist es (Anspruch 12), dass eine Gewichtung zwischen der symmetrischen Durchlass- oder Sperrspannung an den pin-Übergang (22) und dem Gateelektrodenpuls (15) stattfindet, da eine Spannung in Sperr- oder Durchlassrichtung, wie vorhin beschrieben zu einer Verbreiterung oder Auslöschung des kapazitiven Kopplungsfensters führt. In diesem Fall kann das aktive Speichermedium (3) auch durch ein passives Speichermedium (4) ersetzt werden.

In dem Patent WO002018069359A1 wurde bereits das sigmoidale bzw. ReLU Verhalten des Bauelementes für die Modellierung von künstlichen Neuronen geschützt. In neuronalen Netzen kann es während des Trainierens zu einer ungewollten Sättigung kommen, welche man durch abschalten und zuschalten mancher Neuronen umgehen kann (Dropout). Diese Dropout kann durch eine Durchlassspannungen an den pin-/psn-Übergängen erreicht werden (Anspruch 13).

Das Schreiben des Bauelementes im Falle von Ladungsfangstellen (14) im aktiven Speicherdielektrikum (2) kann nach Anspruch 14 entweder über Fowler-Nordheim Tunneln oder mittels Injektion heißer Ladungsträger erfolgen. Die heißen Ladungsträger können beispielsweise im pin-Übergang durch Anlegen einer Spannung generiert werden.

Im folgenden werden die Zeichnungen näher erläutert:

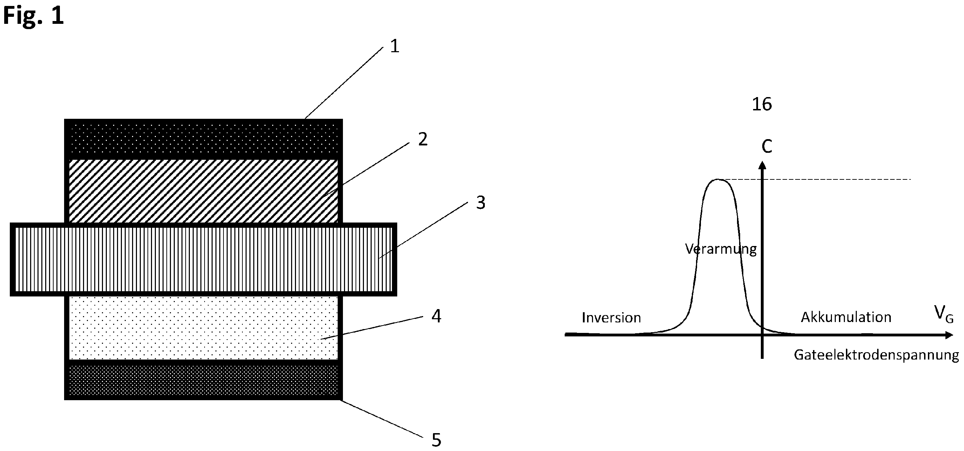

Fig. 1 zeigt den allgemeinen Aufbau des kapazitiven synaptischen Bauelementes und rechts ist die kapazitive Kopplung (16) zwischen Gateelektrode (1) und Ausleseelektrode (5) dargestellt, wobei auf der x Achse die Gatespannung aufgetragen ist und auf der y Achse die Kapazität C. Die Abschirmschicht (3) ist hierbei geerdet und im Fall einer Akkumulation oder Inversion des Halbleiters koppelt praktisch kein elektrisches Feld von der Gatelektrode (1) zur Ausleseelektrode (5) durch. Erst wenn der Halbleiter verarmt wird greift ein Feld durch und folglich tritt eine kapazitive Kopplung (16) ein. Dies äußert sich durch das dargestellte Kopplungsfenster für einen bestimmten Spannungsbereich der Gatespannung.

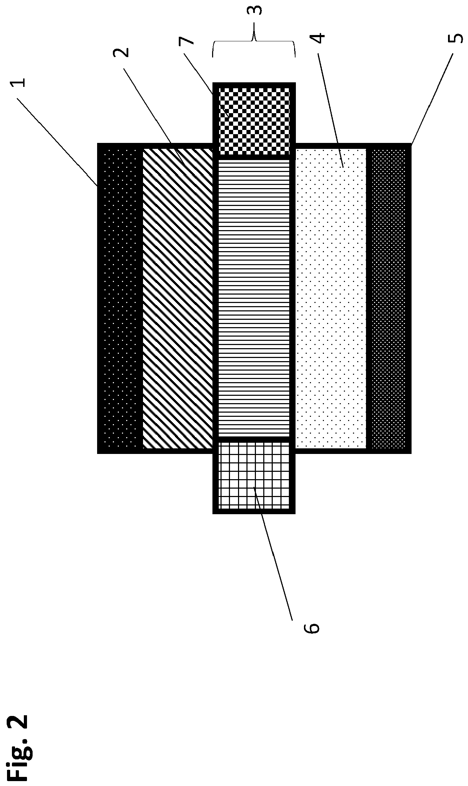

Fig. 2 zeigt den Aufbau des synaptischen Bauelementes mit seitlichen p- (6) und n- (7) Dotierungen, um symmetrisches Schreiben/Löschen und eine weitere Modulationsmöglichkeit zu eröffnen (Anspruch 9-13).

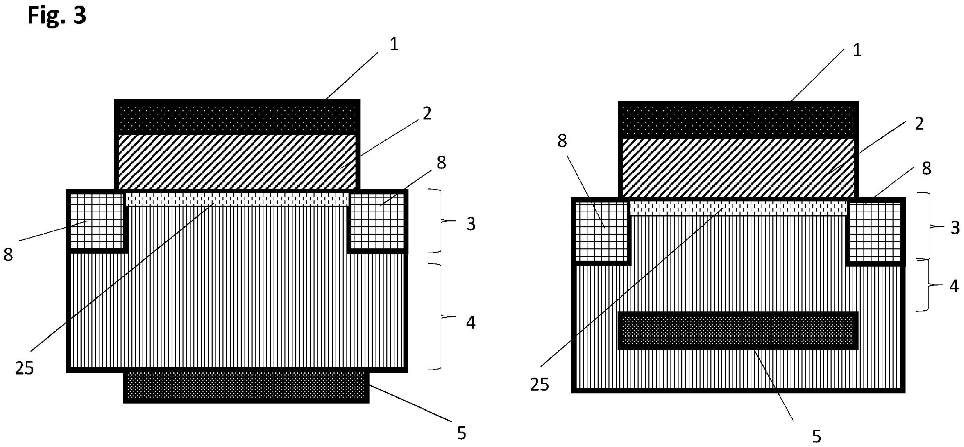

Fig. 3 zeigt einen Aufbau, bei dem die Abschirmschicht (3) und das passive Dielektrikum (4) durch einen oberen und darunterliegenden Halbleiterbereich ausgebildet wird. Die Ausleseelektrode (5) kann hierbei entweder an der Unterseite des Substrates oder zwischendrin angeordnet werden.

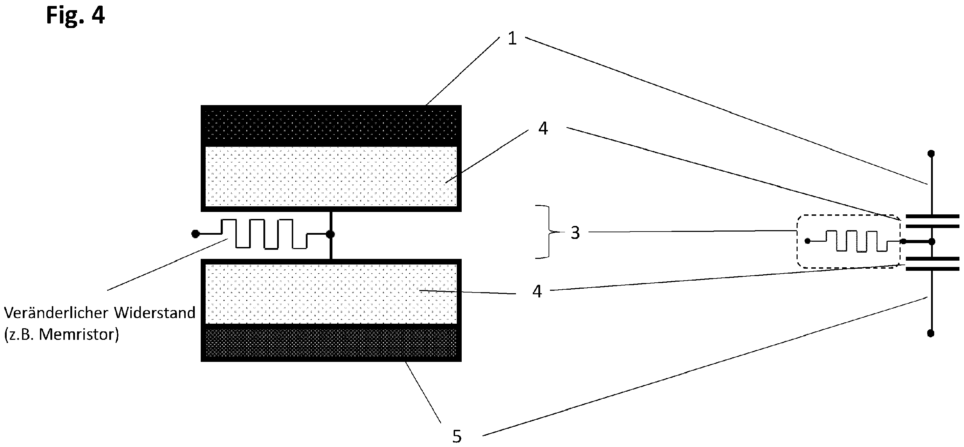

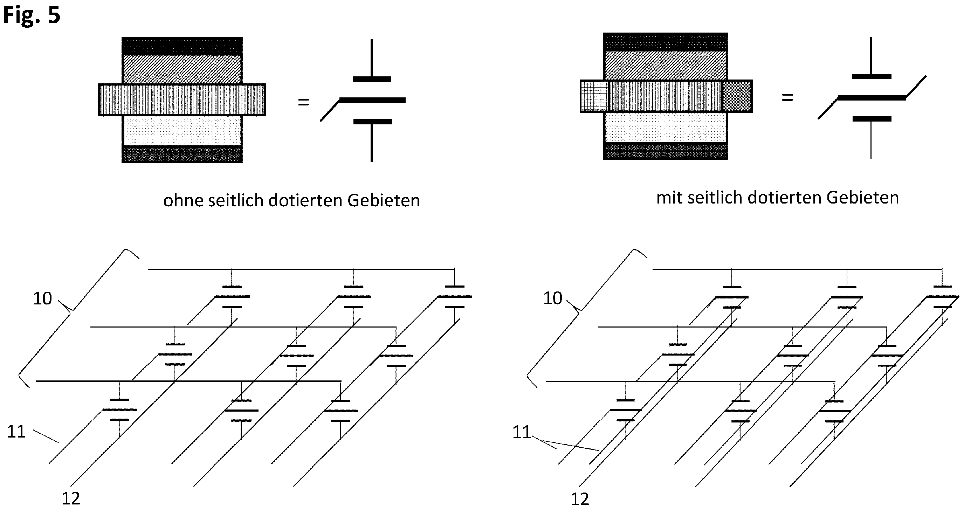

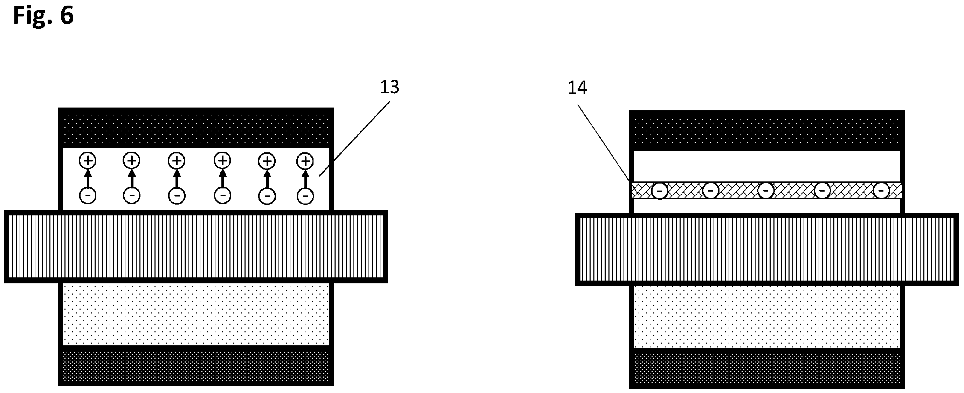

Fig. 4 zeigt den Aufbau, welcher einen veränderlichen Widerstand mit Speicherfunktion (9) als Abschirmschicht (3) ausnutzt. Hierbei kann das aktive Speicherdielektrikum (2) durch ein passives Dielektrikum (4) ersetzt werden, da die Speicherfunktion durch den Widerstand (9) realisiert wird. Fig. 5 zeigt die Anordnung des kapazitiven synaptischen Bauelementes in einer Matrixanordnung, wobei die Gatelektrode (1) mit der Wortleitung (10), die Ausleseelektrode (5) mit der Bitleitung (12) und die Abschirmschicht mit der Abschirmleitung (11) verbunden wird. Fig. 6 zeigt zwei mögliche aktive Speicherdielektrika (3): Ein ferroelektrisches Material (13) auf der linken Seite und ein Dielektrikum mit Ladungsfangstellen (14) auf der rechten Seite.

Fig. 7 zeigt den Ablauf des Auslesens bzw. der Gewichtung des synaptischen Bauelementes. Hierbei wird ein Spannungspuls (15) an die Gatelektrode (1) angelegt und die Abschirmschicht wird geerdet. Je nach Speicherzustand des aktiven Speicherdielektrikums (2) werden die CV-Kurven der kapazitiven Kopplung (16) nach links oder rechts verschoben (18). Wie in der rechten Abbildung dargestellt führt ein Spannungspuls (15) in eine bestimmte Spannungsrichtung zu unterschiedlichen Flächeninhalt, welcher von der CV-Kurve abgedeckt wird. Die akkumulierte Ladung auf der Ausleseelektrode (5) ist proportional zu dieser Fläche. Die akkumulierte Ladung hängt davon ab wie die CV- Kurve verschoben ist durch das Speichermaterial. Die ganz rechte Kurve ist soweit verschoben, dass praktisch keine Ladung auf der Ausleseelektrode (5) akkumuliert, die mittlere hat etwas die hälfte der vollen Ladung und die ganz linke Kurve die volle Ladung. Es sind durch das analoge Speichermaterial beliebige Zwischenstufen möglich.

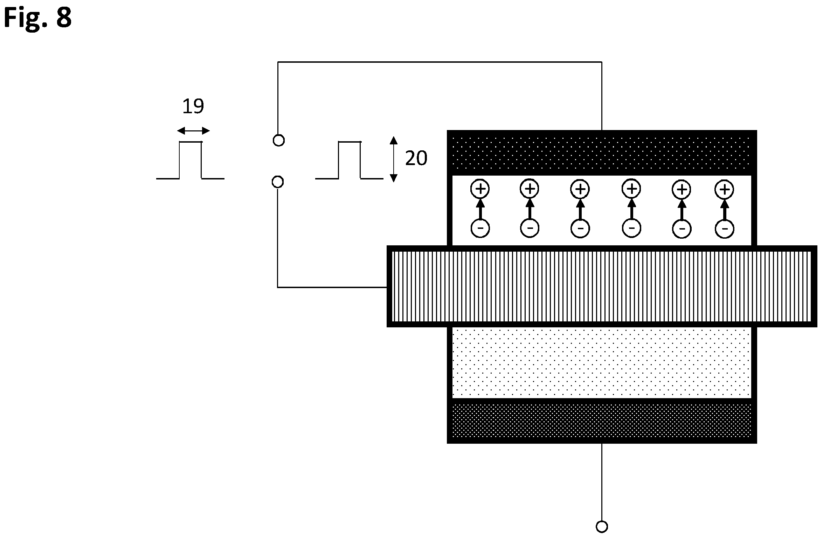

Fig. 8 zeigt den Schreib/Löschablauf des aktiven Speicherdielektrikums (2). Dabei wird eine Spannung zwischen Gateelektrode (1) und Abschirmschicht (2) angelegt. Seitliche p- (6) und n-(7) dotierte Gebiete hätten hierbei den Vorteil einer Symmetrisierung des Schreibvorgangs, da durch die Inversion und Akkumulation sowohl für negative, als auch positive Spannungen gleichermaßen ein hohes Schreibfeld zwischen Abschirmelektrode (3) und Gatelektrode (1) ausbildet. Das Analogwertschreiben kann dabei durch Variation der Pulshöhe (20) oder Pulsdauer (19) erfolgen.

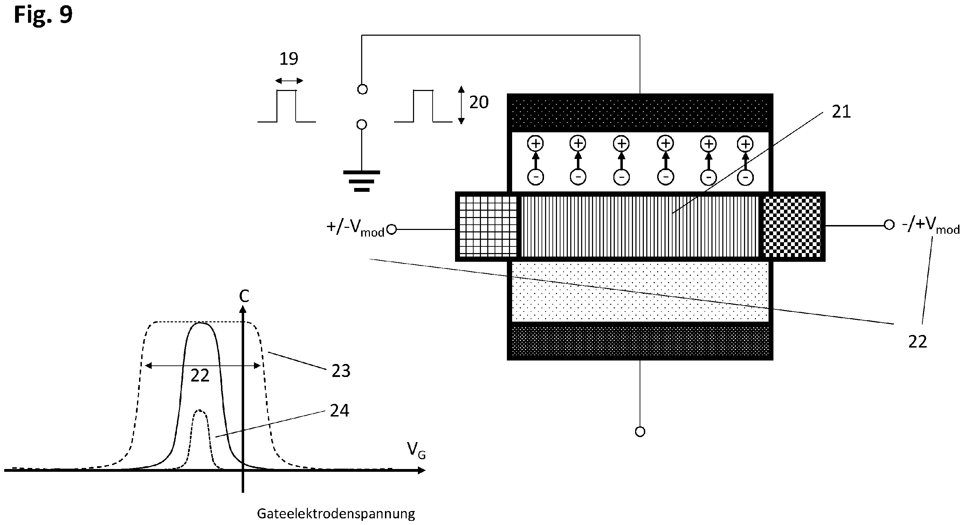

Fig. 9 zeigt die zusätzliche Modulation des Schreibvorgangs mit einer an den pin-Übergängen symmetrisch angelegten Spannung (22). Hierbei wird die Gatespannung bei welcher die Akkumulation oder Inversion einsetzt verschoben, sodass im Falle einer Sperrrichtung (23) die Akkumulation und Inversion bei höheren Gatespannungen einsetzt und im Falle einer Durchlassrichtung (24) die Akkumulation und Inversion bei kleineren Gatespannungen einsetzt. Die Sperrrichtung (23) und Durchlassrichtung (24) führt auch zu einer Verbreiterung bzw. Verschmalerung des Kopplungsfensters der kapazitiven Kopplung zwischen Gatelektrode (1) und Ausleseelektrode (5).

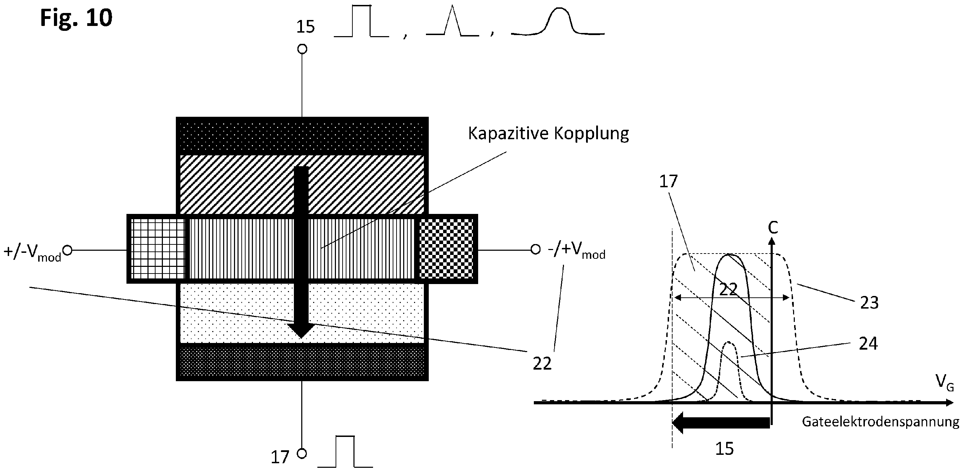

Die Verbreiterung und Verschmalerung des Kopplungsfensters kann auch dazu genutzt werden eine Gewichtung zwischen der an den pin-Übergängen symmetrisch angelegten Spannung (22) und dem Lesepuls (15) durchzuführen (Fig. 10). Hierbei kommt es wie eben beschrieben zu einer unterschiedlich starken Flächenbildung unter der CV-Kurve.

### Bezugszeichenliste

1 - Gateelektrode
2 - Aktives Speicherdielektrikum
3 - Schicht mit veränderlichem Abschirmverhalten gegenüber einer Gateelektrode
4 - passives Dielektrikum
5 - Ausleseelektrode
6 - p-dotiertes Gebiet
7 - n-dotiertes Gebiet
8 - dotiertes Gebiet
9 - veränderlichen Widerstand, welcher seinen Widerstandswert speichern kann
10 - Wortleitungen
11 - Abschirmleitungen
12 - Bitleitungen
13 - ferroelektrisches Material
14 - Ladungsfangstellen
15 - Spannungspuls beim Lesen
16 - Kapazitive Kopplung zwischen Gatelektrode und Ausleseelektrode
17 - Strom oder akkumulierte Ladung auf Ausleseelektrode
18 - Verschiebung der Kapazitiven Kopplung
19 - Schreibpulslänge
20 - Schreibpulshöhe
21 - Verarmung oder Flutung mit Ladungsträgern
22 - Symmetrische Durchlass- oder Sperrspannung an pin-Übergang
23 - Sperrrichtung
24 - Durchlassrichtung
25 - Inversionsschicht

## Patentansprüche

1. Kapazitives synaptisches Bauelement bestehend aus einem Schichtaufbau aus Gateelektrode (1), Ausleseelektrode (5) und Schicht mit veränderlichem Abschirmverhalten gegenüber eines elektrischen Feldes der Gateelektrode (3), einem aktiven Speicherdielektrikum (2) und einem passiven Dielektrikum (4), wobei die Schicht mit veränderlichem Abschirmverhalten (3) zwischen der Gateelektrode (1) und Ausleseelektrode (5) angeordnet ist, **dadurch gekennzeichnet, dass** sich das aktive Speicherdielektrikum (2) zwischen Gateelektrode (1) und Schicht mit veränderlichem Abschirmverhalten (3) befindet und das passive Dielektrikum (4) zwischen der Schicht mit veränderlichem Abschirmverhalten (3) und Ausleseelektrode (5) befindet, des weiteren, dass das aktive Speicherdielektrikum (2) im Stande ist mehrere Zustände zu speichern, und dass das aktive Speicherdielektrikum ausgebildet ist, die kapazitive Kopplung oder Abschirmung gegenüber der Gatespannung zu verschieben.

2. Anordnung nach Anspruch 1 oder 2, **dadurch gekennzeichnet, dass** die Schicht mit veränderlichem Abschirmverhalten (3) aus einem Halbleiter besteht und eine nicht-linearität der kapazitiven Kopplung (16) zwischen Gatelektrode (1) und Ausleseelektrode (5) aufweist, das heißt für bestimmte Spannungsbereiche eine gute kapazitive Kopplung (16) ermöglicht und für andere eine geringe kapazitive Kopplung (16) zwischen der Gatelektrode (1) und Ausleseelektrode (5).

3. Anordnung nach Anspruch 2, **dadurch gekennzeichnet, dass** die Abschirmschicht (3) seitliche hochdotierte p- (6) und n- (7) Gebiete besitzt, und der dazwischenliegende Bereich nur schwach dotiert ist oder intrinsisch, unter Ausbildung eines psn- oder pin-Gebietes.

4. Anordnung nach Anspruch 2, **dadurch gekennzeichnet, dass** ein obere Halbleiterbereich mit seitlichen dotieren Gebieten (8) die Schicht mit veränderlichem Abschirmverhalten (3) bildet, der untere Halbleiterbereich das passive Dielektrikum (4) bildet.

5. Anordnung nach Anspruch 1, **dadurch gekennzeichnet, dass** das aktive Speicherdielektrikum (2) ebenfalls passiv (4) ist und die Abschirmschicht (3) durch einen veränderlichen Widerstand gebildet wird, welcher seinen Widerstandswert speichern kann (9).

6. Anordnung nach Anspruch 1 bis 5, **dadurch gekennzeichnet, dass** die Anordnung aus einer Matrix besteht, bei der die Wortleitung (10) mit der Gateelektrode (1) verbunden ist, die Ausleseelektrode (5) mit der Bitleitung (12) und die Schicht mit veränderlichem Abschirmverhalten (3) mit einer Abschirmleitung (11) verbunden wird, wobei im Falle von seitlichen dotierten Gebieten (6,7,8) für jedes dotierte Gebiet Abschirmleitungen (11) vorhanden sind, wobei die Abschirmleitung (11) der Bitleitung (12) entsprechend ausgeführt ist und die Bitleitungen (12) einen Winkel ungleich Null, vorzugsweise 90°, zu den Wortleitungen (10) bilden.

7. Anspruch nach Anspruch 1 bis 4 und 6, **dadurch gekennzeichnet, dass** das aktive Speicherdielektrikum (2) aus einem ferroelektrischen Material (13) besteht und dieses für eine Spannungsverschiebung der kapazitiven Kopplung (18) in Abhängigkeit der Polarisation sorgt.

8. Anspruch nach Anspruch 1 bis 4 und 6, **dadurch gekennzeichnet, dass** das aktive Speicherdielektrikum (2) Ladungsfangstellen (14) besitzt und diese für einer Spannungsverschiebung der kapazitiven Kopplung (18) in Abhängigkeit der eingefangenen Ladungsmenge sorgt.

9. Verfahren zum Beschreiben und Auslesen einer Anordnung nach Anspruch 1 bis 8 **dadurch gekennzeichnet, dass** beim Beschreiben eine Schreibspannung zwischen der Gateelektrode (1) (Wortleitung (10)) und der Abschirmschicht (3) (Abschirmleitung (11)) angelegt wird und eine graduelle Beschreibung des aktiven Speicherdielektrikums (2) entweder über eine unterschiedliche Schreibpulshöhe (20) oder Schreibpulsdauer (19) erzielt werden kann und dass beim Auslesen das aktive Speicherdielektrikum (2) die kapazitive Kopplung (16) zwischen Gateelektrode (1) (Wortleitung (10)) und Ausleseelektrode (5) (Bitleitung (12)) durch die Abschirmschicht (3) (Abschirmleitung (11)) in einen Spannungsbereich graduell verschiebt und eingestellt werden kann, die Abschirmschicht (3) Abschirmleitung (11) oder dessen hochdotierten Gebiete (6,7,8) geerdet sind, an der Gateelektrode (1) (Wortleitung (10)) ein Spannungspuls (15) angelegt wird und an der Ausleseelektrode (5) (Bitleitung (12)) ein Strom oder akkumulierte Ladung (17) gemessen werden kann, welcher von der Spannungsverschiebung der kapazitiven Kopplung (18), ausgelöst durch das aktive Speicherdielektrikum (2), abhängig ist.

10. Verfahren nach Anspruch 9, **dadurch gekennzeichnet, dass** beim Auslesen die Spannungspulse (15) an alle Wortleitungen (10) parallel angelegt werden und eine gewichtete Multiplikation an den Kreuzungspunkten stattfindet, sowie die Ströme oder akkumulierte Ladungen (17) in der Bitleitung (12) sich summieren.

11. Verfahren nach Anspruch 9, **dadurch gekennzeichnet, dass** das Schreiben des aktiven Speicherdielektrikums (2) zusätzlich moduliert werden kann, indem eine symmetrische Sperr- oder Durchlassspannung (22) an den pin bzw. psn-Übergang angelegt wird.

12. Verfahren nach Anspruch 9, **dadurch gekennzeichnet, dass** beim Lesen eine Gewichtung zwischen einer an den pin-Übergängen symmetrisch angelegten Spannung (22) und dem Spannungspuls (15) an der Gateelektrode (1) (Wortleitung (10)) erfolgt, indem der Spannungsbereich der kapazitiven Kopplung (16) zwischen Gateelektrode (1) (Wortleitung (10)) und Ausleseelektrode (5) (Bitleitung (12)) verändert wird, durch die Spannung an den pin Übergängen (22).

13. Verfahren nach Anspruch 9, wobei beim Lesen das aktive Speicherdielektrikums (2) mit einem passiven Dielektrikum (4) ausgetauscht wird, und das Bauelement zur Modellierung eines Sigmoid oder ReLU Neurons dient, **dadurch gekennzeichnet, dass** während des Dropout Algorithmus Neuronen durch eine Durchlassspannung an den pin-Übergängen abgeschaltet werden können.

14. Verfahren zum Schreiben der Anordnung nach Anspruch 9, **dadurch gekennzeichnet, dass** beim Schreiben entweder Fowler-Nordheim Tunneln oder Injektion von heißen Ladungsträgern zum Einsatz kommen kann, wobei diese im pin-Übergang durch Anlegen einer Spannung generiert werden können.
